# EUROPEAN PATENT APPLICATION

(11) **EP 1 722 396 A2**
(43) Date of publication of application: **15.11.2006**
(21) Application number: 05024831.9
(22) Date of filing: 14.11.2005
(51) Int. Cl.: H01J 37/20

(54) **Method of operating high-pressure chamber in vacuum or low-pressure environment and observing the operation and device therefor**

(30) Priority: 09.05.2005 CN 200510070170
(71) Applicant: Lee, Bing-Huan, Niaosong Township Kao hsiung 833 (TW)
(72) Inventor: Chao, Chih-Yu, Da-An District Taipei City 106 (TW); Hsieh, Wen-Jiunn, Jhonghe City Taipei County 235 (TW)
(74) Representative: Becker Kurig Straus

(57) **Abstract**

A method of operating a high-pressure chamber in a vacuum or low-pressure environment and observing the operation, and a device for the operation and the observation respectively, employs a housing, which includes a chamber, a vapor room, at least one buffer room, at least one spacer, and all of vapor, inner, and outer apertures formed on the spacer and coaxially aligned with one another. Infusing a fluid of higher pressure into the chamber with a pressurizer and applying multilayered depressurization to the outside of the chamber and controlling the pressure difference between the chamber and the vapor room to prevent the fluid from exhausting like liquid through the vapor aperture and instead ensure the fluid to be held inside the chamber. The coaxial relationship of the vapor, inner, and outer apertures enables a probing source to penetrate through the fluid for observation and analysis.

## Description

### BACKGROUND OF THE INVENTION

### 1. Field of the Invention

The present invention relates generally to technology for operating a high-pressure sub-environment in a vacuum or low-pressure environment, and more particularly, to a method of operating a high-pressure chamber in a vacuum or low-pressure environment and observing the operation, and to a device for the operation and the observation.

### 2. Description of the Related Art

It is known in the field of microscopic observation to employ an electron microscope with its high-power magnification to do scientific research on a nanometer substance.

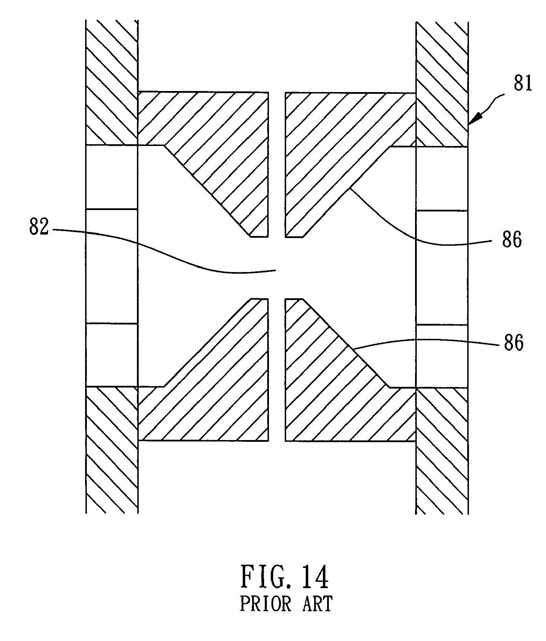

A conventional electron microscope works by utilizing an electron beam to probe the substance. It is necessary to utilize the accelerated electron beam by high voltage and to focus the electron beam by using the electromagnetic lenses to do the microscopic observation in a vacuum environment. As shown in FIG. 14, an electron microscope 81 includes a vacuum specimen chamber 82 for receiving a specimen, and an upper pole piece 86 and a lower pole piece 86 both located in the specimen chamber 82 for ensuring precise focus of the electron beam. The distance between the two pole pieces 86 is 1cm or so. However, any specimen received in the specimen chamber 82 must be a non-volatile or hardly volatile substance other than fluid, like liquid or gas, to allow observation in the vacuum environment. If the substance is volatile, for example a fluid such as a liquid, it is subject to immediate boiling, volatilization, or the like.

To overcome the above problem and to allow the specimen received in the electron microscope to be observed and analyzed under an environment in which a specific fluid can exist, Kalman (Kalman E. et al., J. Appli. Cryst. 7, 442, 1974) conducted an experiment that attempted to observe the structure of water under an electron microscope in 1974. However, the Kalman's experiment lacked a structure of vapor and buffer chambers, and instead exposed the water directly to the vacuum environment, enabling the water to immediately become boiled or volatilized into vapor. Although observation could still be done in the experiment, it could only be done for a very short time. According to prior documentation, the water film could exist for seconds only. Because most of the observations and analyses cannot to be accomplished in such a short time, such technology is in general not practicable.

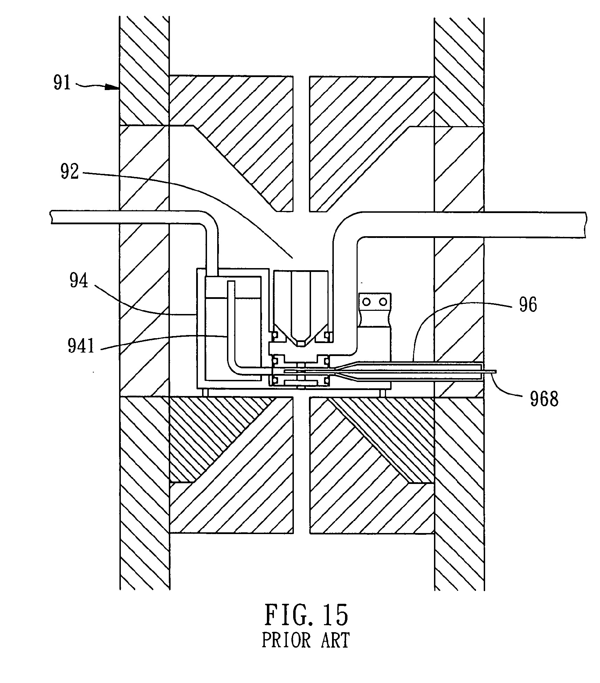

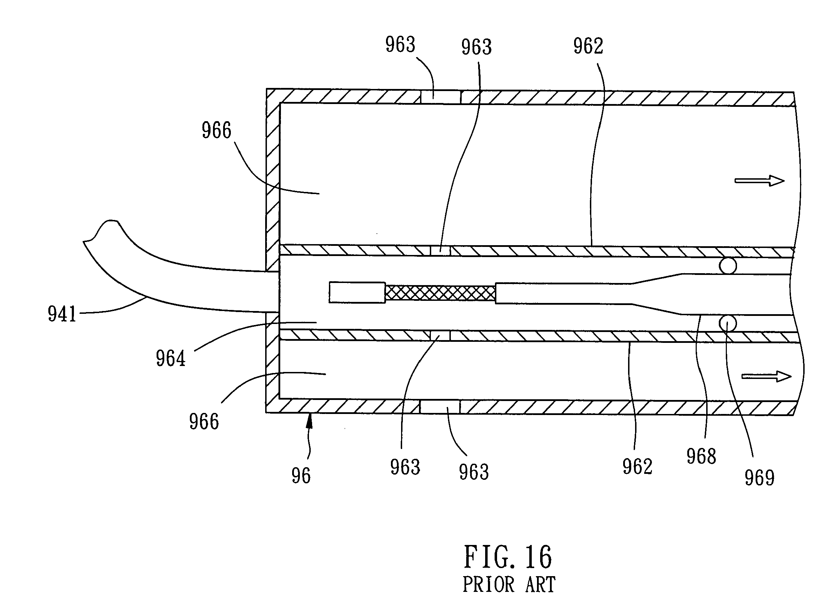

In addition to Kalman's experiment, Hui et al. presented an environment chamber for controlling water vapor (Hui S. W. et al., Journal of Physics E 9, 72, 1976) in an electron microscope 91. As shown in FIGS. 15 and 16, the electron microscope 91 includes a heightened specimen chamber 92, a water tank 94 mounted inside the specimen chamber 92, and an environment chamber 96. The environment chamber 96 has two spacers 962 partitioning its center into a vapor layer 964 and two buffer layers 966 located respectively below and above the vapor layer 964. The water tank 94 has a vent pipe 941 connected with the vapor layer 964 for providing the vapor layer 964 with vapor. The two spacers 962 and top and bottom sidewalls of the environment chamber 96 are parallel to one another, each having an aperture 963. The apertures 963 are coaxially aligned with one another for penetration of the electron beam. The environment chamber 96 further has a specimen tube 967 extending outwards from the vapor layer 964, a specimen holder 971 extending through the specimen tube 967 into the vapor layer 964 from outside the electron microscope 91, and an O-ring 972 sealing space between the specimen holder 971 and the vapor layer 964 for insulation between the vapor layer 964 and the outside the electron microscope 91.

However, the aforementioned structure and prior art can only control the environment chamber 96 to internally keep a gasiform or water vapor environment other than a liquid one, and fail to enable its pressure to reach the standard atmospheric pressure.

Another research group for modification of the electron microscope presented an experiment of observation of gasiform, liquid, and solid chemical reactions under the electron microscope in 2002 (Gai P. L., Microscopy & Microanalysis 8, 21, 2002). However, such design has the following drawbacks. The pressure of the specimen chamber still fails to keep close to or higher than the standard atmospheric pressure for observation and analysis. As a result, the liquid in the specimen chamber immediately fully volatilizes if partial pressure of the vapor fails to reach its saturated pressure, thus requiring supplementary liquid for entry into the specimen target holder to continue observation. However, such entry of supplementary liquid causes serious problems of flow or uneven admixture of new and original specimens to result in inauthenticity of the observation. In addition, the massive volatilized high-pressure vapor or the outside high-pressure gas infused into the gas chamber fills the space (about or more than 1cm) between the pole pieces to cause the more serious effect of multiple scattering of the electrons resulting from electrons impinging on excessive gasiform molecules, further disabling successful imaging of the electron beam or experiment of electron diffraction. Meanwhile, the specimen chamber in this design fails to effectively control the amount of the infused liquid, easily causing excess thickness of the liquid to further disable penetration of the electron beam through the specimen and thus disabling the observation and analysis.

Further, it is necessary to disassemble the primary part of the electron microscope before installing the whole system of Gai's design, such that it is hardly possible to mass-produce the system.

Another window-type design/experiment was disclosed by Daulton T.L. (Daulton T.L. et al., Microscopy Research & Technique 7, 470, 2001). Although the design of Daulton can avoid the aforementioned problems incurred after the volatilization of the liquid, it tends to cause multiple scattering of the electrons due to thick window film disabling successful imaging of the electron beam or experiment of electron diffraction. Even if the analysis and observation can be done, the resolution is still greatly reduced. Further, operation of the window-type specimen under the standard atmospheric pressure or higher will cause an excess pressure difference between the window-type specimen and the specimen chamber to rupture the window film, causing immediate volatilization of the liquid into the vacuum area inside the electron microscope, greatly reducing the vacuum level of the vacuum area and further disabling the operation.

The above-mentioned prior arts fail to keep a liquid sub-environment at standard atmospheric pressure or higher in the vacuum or low-pressure environment for operation and observation by an electron microscope. To solve this problem, the present invention provides an advanced technology for keeping a fluid sub-environment at standard atmospheric pressure or higher in the vacuum or low-pressure environment for operation and observation under the electron microscope without alteration of the original design of the electron microscope.

### SUMMARY OF THE INVENTION

The primary objective of the present invention is to provide a method of operating a high-pressure chamber in a vacuum or low-pressure environment and observing the operation, and a device for the operation and observation, thereby enabling a fluid sub-environment whose pressure is equal to or higher than one atmospheric pressure or higher than the outside pressure to be maintained in the vacuum or low-pressure environment for observation and analysis.

The secondary objective of the present invention is to provide a method of operating a high-pressure chamber in the vacuum or low-pressure environment and observing the operation, and a device for the operation and observation, thereby providing a fluid environment of higher pressure than outside for observation and analysis without alteration of the original design of the electron microscope.

The foregoing objectives of the present invention are attained by a method which includes the following steps:
a) Prepare a housing, wherein the housing has a chamber therein and at least one spacer partitioning its interior space into at least one vapor room formed outside the chamber and at least one buffer room formed outside the vapor room; the chamber contains a fluid specimen, connected with a pressurizer for providing the fluid specimen with a predetermined pressure; two vapor apertures are formed on a top side and a bottom side of the chamber respectively, for communication between the chamber and the vapor room; two inner apertures are located respectively above and below the two vapor apertures and formed respectively on the spacer located between the vapor room and the buffer room for communication between the vapor room and the buffer room; the housing has two outer apertures formed respectively on its top and bottom sides for communication with outside of the housing; the inner and outer apertures are coaxially aligned with the vapor apertures; and the housing further has a gas inlet and a pumping port corresponding respectively to the vapor room and the buffer room;
b) Put the housing in the vacuum or low-pressure environment, and keep a predetermined temperature difference between each two of the chamber, vapor room, and buffer room;
c) Utilize the pressurizer to keep providing the fluid specimen with a predetermined pressure and to maintain the fluid specimen under consistent pressure, wherein the predetermined pressure is larger than the ambient pressure outside the housing, and infuse a gas into the vapor room and control the pressure difference between the vapor room and the chamber to be lower than a critical pressure that the fluid inside the chamber flows like liquid out of the vapor apertures to prevent the fluid from flowing out of the vapor aperture, wherein the fluid specimen slowly volatilizes through the vapor apertures into the vapor room; and the volatilization rate of the fluid specimen is very low and far lower than 3.3×10⁻⁵ g/sec so as not to affect the resolution of the electron microscope (Hui S. W. et al., Journal of Physics E 9, 72, 1976); meanwhile, the gas and vapor inside the vapor room can slowly leak through the inner apertures into the buffer room; and
d) Evacuate the buffer room through the pumping ports at a predetermined rate to pump out the gas and vapor from the buffer room and to prevent the gas and vapor from leaking through the outer apertures out of the housing.

Thus, the present invention provides a high-pressure chamber in a vacuum or low-pressure environment to allow the electron beam, ion beam, atom beam, neutron beam, X ray, and another high-coherent beam to pass through the outer, inner, and vapor apertures to conduct observation and analysis of the fluid specimen inside the high-pressure chamber.

In addition, more than two buffer rooms can be mounted respectively above and below the vapor room to enable more flexible maneuverability of the pumping rates for the gas inside the buffer rooms and to control the pumping rates under appropriate condition, enabling the gas and vapor inside the buffer rooms to be fully evacuated without causing exhausting through the outer apertures out of the housing while maintaining the gas pressure inside the vapor room to reach or exceed the standard atmospheric pressure.

Further, the present invention also provides a high-pressure gasiform chamber and the operation of the chamber, which can be done by a gas in replace of the fluid specimen inside the chamber infused into the pressurizer indicated in the aforesaid steps, therefore keeping the chamber under a high pressure.

Another aspect of the present invention is to provide a device for operating a high-pressure chamber in a vacuum or low-pressure environment and observing the operation. The device includes a housing. The housing has a chamber and at least one spacer partitioning its interior space into at least one vapor room formed outside said chamber, and at least one buffer room formed outside said vapor room. The chamber contains a fluid. A pressurizer is connected with said chamber to keep providing the fluid specimen inside the chamber with a predetermined pressure. The chamber has two vapor apertures on its top and bottom sides for communication with the vapor room. Two inner apertures are formed on the at least one spacer between the vapor room and the buffer room for communication between the vapor and buffer rooms. The two inner apertures are located respectively above and below said vapor aperture. The housing has two outer apertures formed on its top and bottom sides for communication with outside thereof. The inner, outer, and vapor apertures are coaxially aligned with one another. The housing has at least one gas inlet corresponding to the vapor room and at least one pumping port corresponding to the buffer room.

### BRIEF DESCRIPTION OF THE DRAWINGS

FIG. 1 is a partially sectional perspective view of a first preferred embodiment of the present invention.
FIG. 2 is a sectional view of the first preferred embodiment of the present invention.
FIG. 3 is a schematic view of the first preferred embodiment of the present invention in cooperation with the electron microscope.
FIG 4 is a partially sectional perspective view of a second preferred embodiment of the present invention.
FIG. 5 is a sectional perspective view of the second preferred embodiment of the present invention.
FIG. 6 is a sectional view of a third preferred embodiment of the present invention.
FIG. 7 is a partially sectional perspective view of the third preferred embodiment of the present invention.
FIG. 8 is a schematic view of the third preferred embodiment of the present invention in cooperation with the electron microscope.
FIG 9 is a sectional view of a fourth preferred embodiment of the present invention.
FIG. 10 is a partially enlarged view of FIG 9.
FIG. 11 is a sectional view of a fifth preferred embodiment of the present invention.
FIG. 12 is a sectional view of a sixth preferred embodiment of the present invention.
FIG. 13 is a partially enlarged view of FIG 12.
FIG 14 is an internal part of a conventional electron microscope.
FIG 15 is a sectional view of the prior art in cooperation with the electron microscope.
FIG 16 is a partially sectional view of the prior art.

### DETAILED DESCRIPTION OF PREFERRED EMBODIMENTS

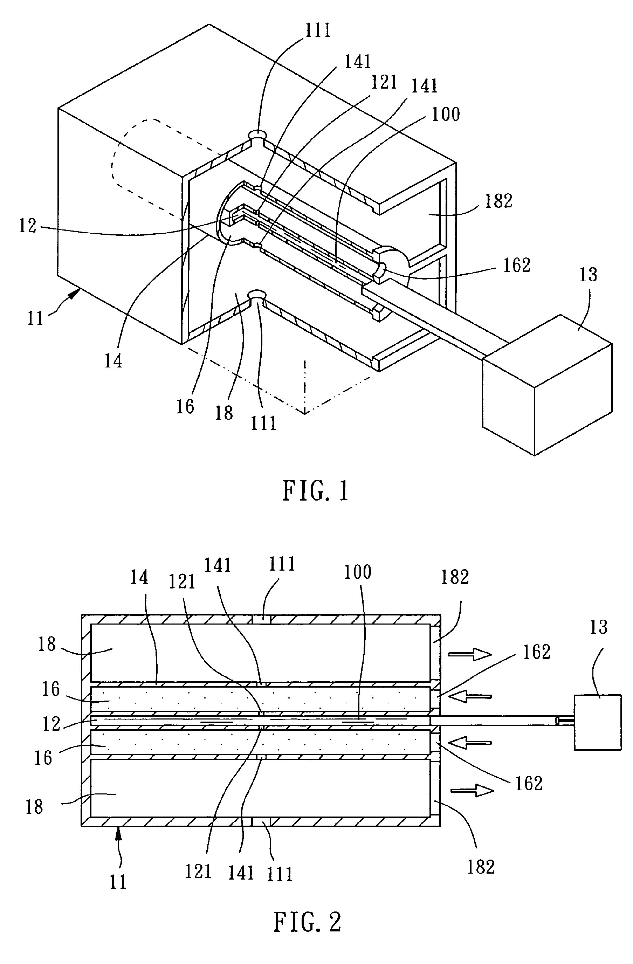

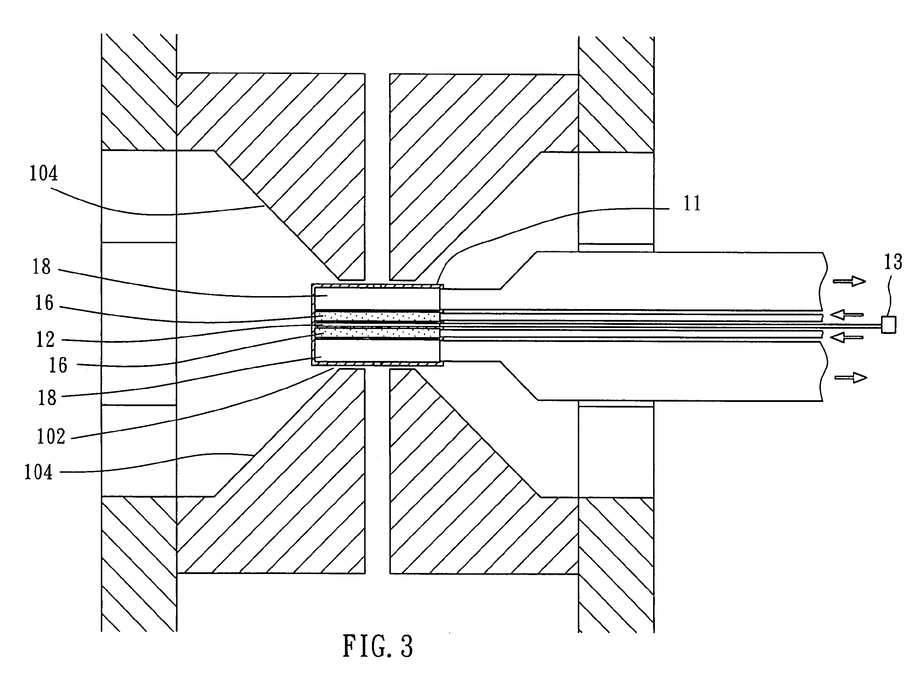

Referring to FIGS. 1-3, a method of operating a high-pressure chamber in a vacuum or low-pressure environment and observing the operation in accordance with a first preferred embodiment of the present invention includes the following steps:
A. Prepare a housing 11, as shown in FIGS. 1 and 2. The housing 11 has a chamber 12 therein and a spacer 14 therein. The spacer 14 partitions an interior space of the housing 11 into a vapor room 16 and a buffer room 18 formed respectively outside the chamber 12 and the vapor room 16. The chamber 12 contains a fluid specimen 100 therein, such as water, which is smaller in thickness than 30µm. A pressurizer 13 is connected with the chamber 12 for providing the fluid specimen 100 with a predetermined pressure or for supplementing the fluid specimen 100 or other substance to be analyzed. The chamber 12 has two vapor apertures 121, which are formed on a top side and a bottom side of the chamber 12 respectively and each of which has a diameter of 5-100µm, for communication with the vapor room 16. Two inner apertures 141, each of which has a diameter of 10-200µm, are formed on the spacer 14 and located respectively above and below the vapor apertures 121 for communication between the vapor and buffer rooms 16 and 18. The housing 11 has two outer apertures 111, each of which has a diameter of 20-800µm and is formed on a top (bottom) side of the housing 11 for communication between the buffer room 18 and a vacuum section outside the housing 11. The outer apertures 111 are coaxially aligned with the inner apertures 141 and the vapor apertures 121. Each of the outer apertures 111 is larger in diameter than the inner aperture 141. The housing 11 has two gas inlets 162 and two pumping ports 182 corresponding respectively to the vapor room 16 and the buffer room 18.
B. Put the housing 11 in the vacuum or low-pressure environment, as shown in FIG 3, such as the vacuum environment between the two pole pieces 104 inside the specimen chamber 102 of an electron microscope, and keep a predetermined temperature difference between each two of the chamber 12, fluid specimen 100, vapor room 16, and buffer room 18; the predetermined temperature in this embodiment is defined zero or within 10 degrees Celsius (10°C).
C. Keep supplying the fluid specimen 100 into the chamber 12 at the predetermined pressure by using the pressurizer 13 to maintain the fluid specimen 100 under consistent pressure which is larger than that of the specimen chamber 102 of the electron microscope, and simultaneously infuse gas of pressure close to that of the chamber 12 into the vapor room 16. The predetermined pressure is larger than 50 torrs and can be up to 200 torrs in this embodiment. The infused gas can be the vapor (water vapor) of the fluid specimen, a specific gas, or a mixture of the vapor and the specific gas under the same temperature. The specific gas can be nitrogen (N₂), oxygen (O₂), carbon dioxide (CO₂), another inert gas, or a mixture of the aforesaid gases. The infused gas is smaller than or equal to the vapor room 16 and the chamber 12 in temperature to prevent the vapor from condensation inside the vapor room 16. The infused gas into the vapor room 16 can be controlled to enable the pressure difference between the vapor room 16 and the chamber 12 to be lower than the critical pressure (Keller S. et al., Journal of Food Protection 66, 1260, 2003) that the fluid will flow out like liquid of the vapor apertures 121, thus preventing the fluid specimen 100 inside the chamber 12 from flowing out of the vapor apertures 121, wherein the fluid specimen 100 slowly volatilizes through the vapor apertures 121 into the vapor room 16. In the meantime, the gas and vapor inside the vapor room 16 can exhaust through the inner apertures 141 into the buffer room 18.
D. Evacuate the buffer room 18 through the two pumping ports 182 at a predetermined pumping rate to pump out the gas and vapor from the buffer room 18 and to prevent the gas and vapor from leaking through the outer apertures 111 out of the housing 11.

The aforementioned method can provide a high-pressure chamber 12 in the vacuum or low-pressure environment and enable the observation of the fluid specimen 100 through the outer, inner, and vapor apertures 111 and 141 and 121. The pressure inside the chamber 12 can be provided by the pressurizer 13; further, a diameter of the vapor aperture 121 is very small to cause limitation, the pressure difference between the chamber 12 and the infused gas through the gas inlets 162 into the vapor room 16 is very small (smaller than the critical pressure), and the fluid specimen 100 is very thin and light to be negligible in weight, thus disabling the fluid specimen 100 to flow like liquid out of the vapor apertures 121, wherein the fluid specimen 100 slowly volatilizes into the vapor room 16. Thus, the present invention provides a stable and high-pressure fluid environment for penetration of another electron beam or other high-coherent beam such as an ion beam, atom beam, neutron beam, laser beam, and X ray, through the outer, inner, and vapor apertures 111 and 141 and 121 for the observation of the fluid specimen 100 inside the chamber 12.

In step C of the first embodiment, before infusing the fluid specimen 100 into the chamber 12 by means of the pressurizer 13, the user can evacuate the vapor room 16 through the two gas inlets 162 and keep a predetermined temperature difference (not larger than 10°C) between the chamber 12 and the vapor room 16, and then infill the fluid specimen 100 or other desired substance into the chamber 12 by the pressurizer 13. In the meantime, the infilled specimen can quickly enter the chamber 12 because there exists a larger difference of pressure or concentration between the vapor room 16 and the chamber 12, and the liquid fluid exhausted through the vapor apertures 121 immediately become boiled or volatilized under the extremely low-pressure environment inside the vapor room 16 and then evacuated. After the chamber 12 is full of the fluid specimen 100, the gas is infused back into the vapor room 16 and evacuation of the buffer room 18 continues. Next, the gas is infused through the gas inlets 162 into the vapor room 16 and the gas is controlled under a predetermined temperature and pressure to prevent the fluid specimen 100 inside the chamber 12 from flowing out of the vapor aperture 121 due to a larger pressure difference (larger than the critical pressure) existing between the vapor room 16 and the chamber 12; meanwhile, the fluid specimen 100 can be still slowly volatilized and transformed into vapor to exhaust through the vapor aperture 121 into the vapor room 16, and the pressurizer 13 can keep supplementing the fluid specimen 100 for tiny amount of exhausted vapor to maintain the fluid specimen 100 inside the chamber 12.

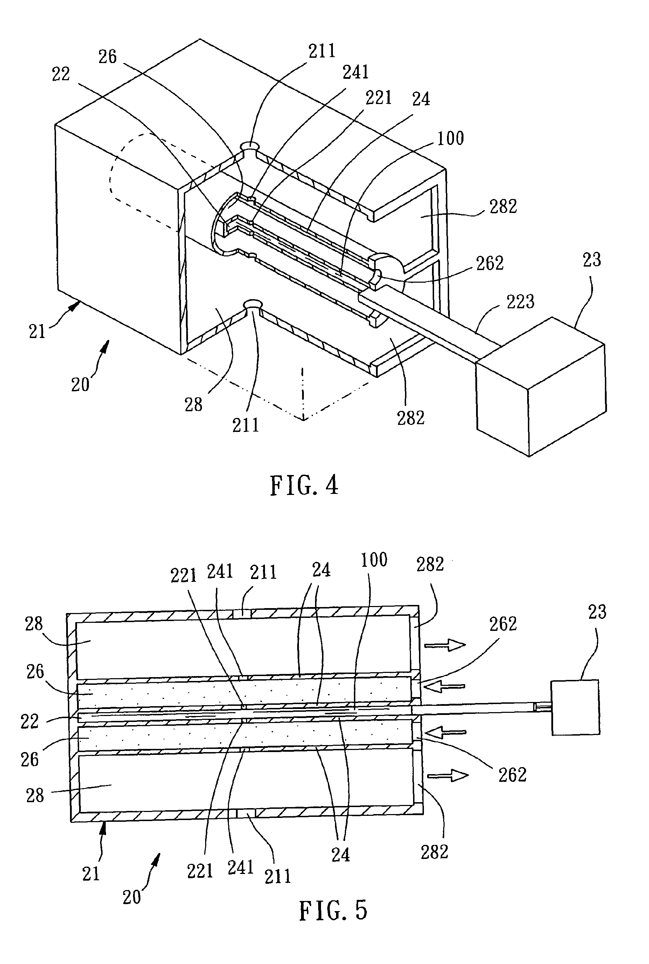

Referring to FIGS. 4-5, a device 20 for operating the high-pressure chamber in the vacuum or low-pressure environment and observing the operation in accordance with a second preferred embodiment of the present invention includes a housing 21. The housing 21 has a chamber 22 and a spacer 24 both formed therein, having an overall height of 1cm or smaller. The spacer 24 partitions the interior space of the housing 21 into a vapor room 26 and a buffer room 28 formed respectively outside the chamber 22 and the vapor room 26. The vapor room 26 surrounds the chamber 22, and the buffer room 28 surrounds the vapor room 26.

The chamber 22 is filled with a fluid specimen 100, like water, having a thickness of less than 30µm, and connected with a guiding pipe 223 and a pressurizer 23. The pressurizer 23 is a liquid pressurizer and is connected with the guiding pipe 223 for providing the fluid specimen 100 with a predetermined pressure or for supplementing the fluid specimen 100 or other substance to be analyzed. A vapor aperture 221 having a diameter of 5-100µm is formed on a top side and a bottom side of the chamber 22, for communication between the chamber 22 and the vapor room 26. Two inner apertures 241, each of which has a diameter of 10-200µm, are formed on the spacer 24 and located respectively above and below the vapor aperture 221 for communication between the vapor room 26 and the buffer room 28. Two outer apertures 211, each of which has a diameter of 20-800µm, are formed on the top and bottom sides of the housing 21 for communication between the buffer room 28 and the vacuum section. The outer, inner, and vapor apertures 211 and 241 and 221 are coaxially aligned with one another. The housing 21 has two gas inlets 262 and two pumping ports 282. The two gas inlets 262 correspond to the vapor room 26. The two pumping ports 282 correspond to the buffer room 28.

The device 20 of the second embodiment of the present invention is operated in the same manner as that of the first preferred embodiment, and therefore further description of the method is not necessary. It is to be noted that the height of the housing 21 fits the distance between the two pole pieces of the electron microscope.

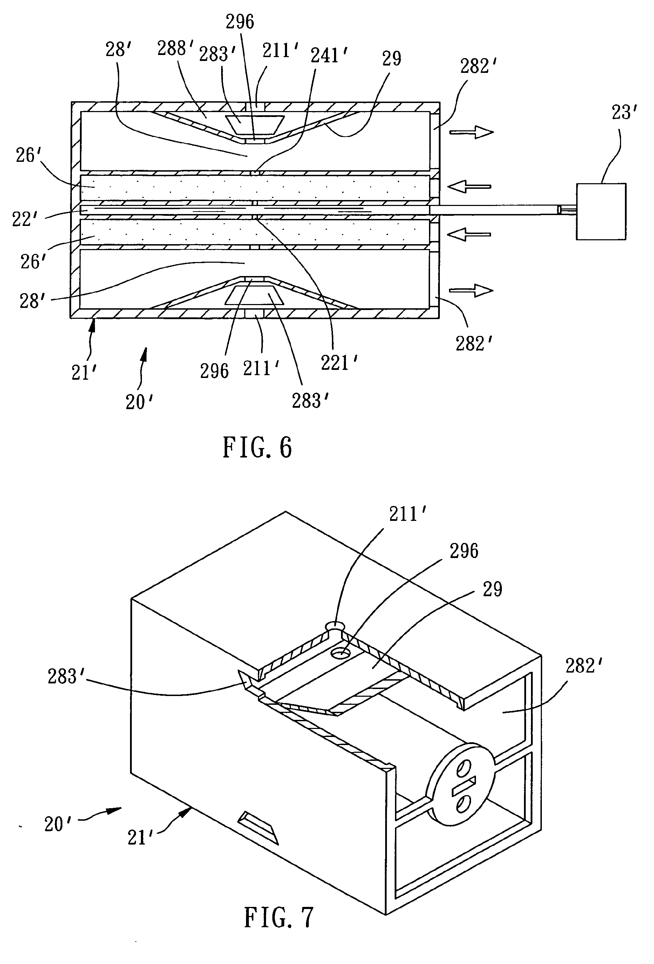

Referring to FIGS. 6-8, the device 20' for operating the high-pressure chamber in the vacuum or low-pressure environment and observing the operation in accordance with a third preferred embodiment of the present invention is similar to that of the second embodiment, but having the differences described below.

The housing 21' includes two inclined spacers 29 formed in the buffer room 28' for creating two auxiliary buffer rooms 288' inside said buffer room 28'. Each of the inclined spacers 29 has a buffer aperture 296, which has a diameter of 10-400µm, between those of the inner and outer apertures 241' and 211'. The two buffer apertures 296 are located above and below the inner aperture 241' respectively and coaxially aligned with the inner and outer apertures 241' and 211'. The buffer room 28' corresponds to the two pumping ports 282' of the housing 21', and the two auxiliary buffer rooms 288' correspond respectively to the two pumping ports 283'. Thus, the present invention employs the inclined spacers 29 in this embodiment to increase the number of the buffer room 28' without increasing the height of the housing 21'.

The two auxiliary buffer rooms 288' and the buffer room 28' are differentially pumped to achieve multilayered depressurization and enable more flexible maneuverability over the pumping rates thereof for greater pressure buffering and to enable the pressure of the gas infused into the vapor room 26' to reach 760 torrs (one atmospheric pressure) to further enable the pressure working on the fluid specimen 100 (as liquid in this embodiment) inside the chamber 22' through the pressurizer 23' to reach one atmospheric pressure or higher at the same time. The pressure working on the fluid specimen 100 inside the chamber 22' through the pressurizer 23' can be increased up to 780 torrs. The difference between the pressure of the infused gas into the vapor room 26' and the pressure of the fluid specimen 100 inside the chamber 22' is controlled to be lower than the critical pressure above which the fluid inside the chamber 22' will flow out like liquid of the vapor aperture 221'. For example, in this embodiment, the critical pressure for preventing the fluid specimen 100 from flowing out of the vapor aperture 221' is lower than 20 torrs when the vapor aperture is 20µm in diameter. In the meantime, the fluid specimen 100 can be still slowly volatilized and transformed into vapor to exhaust through the vapor aperture 121 into the vapor room 16. The infused gas into the vapor room 26' can alternatively be a mixture with one atmospheric pressure (760 torrs) in total of nitrogen, another inert gas, and saturated liquid vapor having the same temperature as that of the fluid specimen 10 for further reducing the volatilization_rate_of fluid specimen 100 volatilized into vapor. The infused nitrogen or helium or other gas must be heated in advance to control the temperature thereof to be equal to or slightly larger than that of the vapor of the fluid specimen 100, to prevent the vapor of the fluid specimen 100 from condensation inside the vapor room 26'. The buffer room 28' and the two auxiliary buffer rooms 288' are controlled at pumping rates respectively higher than 160 L/sec and 240 L/sec and the pumping rate of the two auxiliary buffer rooms 288' is kept larger than that of the buffer room 28' to avoid pumping backflow, to enable the gas and vapor exhausting into the two auxiliary buffer rooms 288' to be evacuated, and to prevent the gas and vapor from leaking through the outer apertures 211' out of the housing 21'. Meanwhile, the gas pressure inside the vapor room 26' can be maintained under the standard atmospheric pressure.

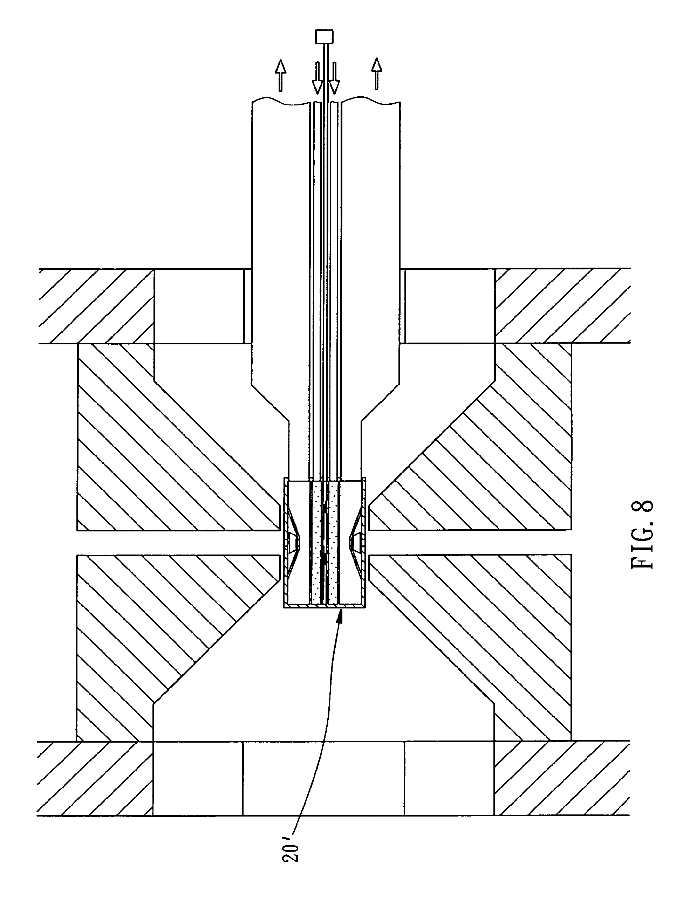

The other operation of the third embodiment is substantially the similar as that of the above-mentioned embodiment such that no further description is necessary. The height of the housing 21', as shown in FIG. 8, fits the distance between the pole pieces inside the electron microscope.

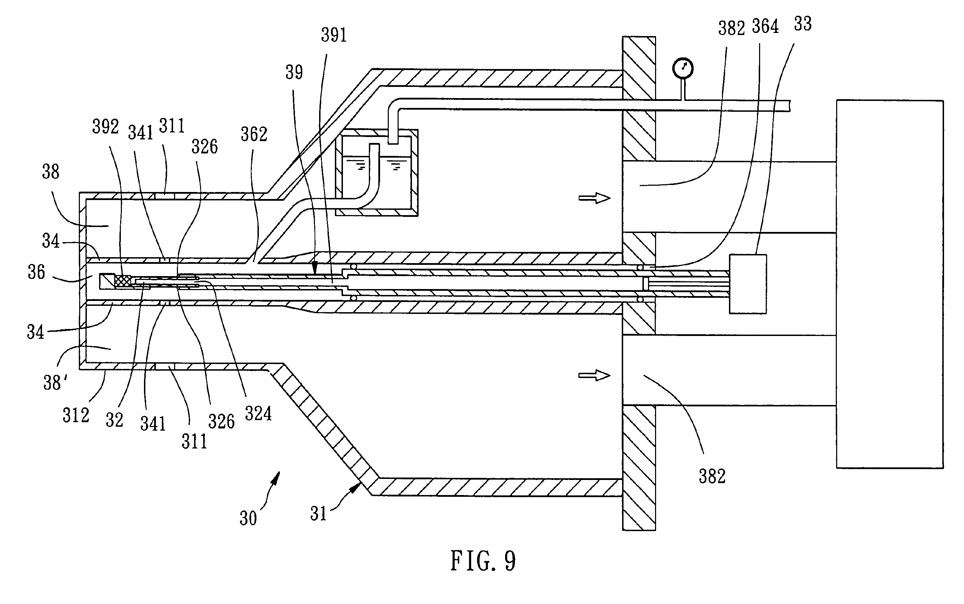

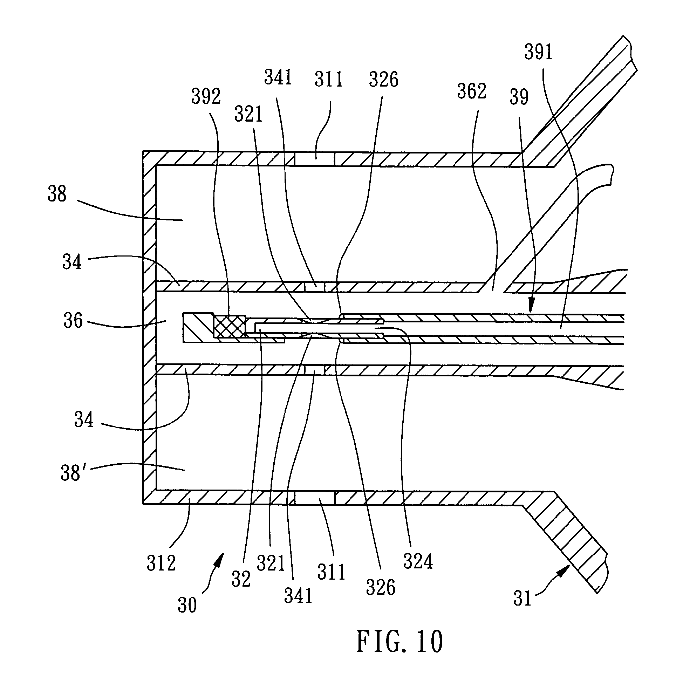

Referring to FIGS. 9 and 10, the device 30 for operating the high-pressure chamber in the vacuum or low-pressure environment and observing the operation in accordance with a fourth preferred embodiment of the present invention is similar to the second embodiment, but has the differences described below.

The housing 31 includes a thinner part 312 formed at one side and being about 1cm high or lower. The inner and outer apertures 341 and 311 are located on the thinner part 312. The housing 31 includes a plurality of spacers 34 therein further partitioning its interior space into an upper buffer room 38 and a lower buffer room 38' located respectively above and below the vapor room 36, a gas inlet 362 corresponding to the vapor room 36, and two pumping ports 382 corresponding respectively to the upper and lower buffer rooms 38 and 38'.

The housing 31 further includes a hollow specimen holder 39 and an insertion slot 364 for communication with the vapor room 36. The specimen holder 39 is inserted through the insertion slot 364 into the vapor room 36, and has a guiding pipe 391 formed therein. The chamber 32 is a box-like member, is embedded partially into the specimen holder 39, and has an opening 324 at its one end for communication with the guiding pipe 391. Each of the vapor apertures 321 located respectively on the top and bottom sides of the chamber 32 is taper-shaped, whereby the thickness of each sidewall is the smallest at the center of the sidewall surrounding the vapor aperture 321. The pressurizer 33 is a liquid pressurizer connected with the guiding pipe 391. The chamber 32 is connected with the specimen holder 39 by an adhesive 326. The specimen holder 39 includes a retaining wall 392 surrounding the chamber 32 for securing the chamber 32 in position.

The operation of the fourth embodiment is identical to that of the second embodiment such that no further description is necessary. Even though the pressurizer 33 provides the fluid specimen 100 inside the chamber 32 with pressure, the chamber 32 is not forced to depart from the specimen holder 39 by the pressure because the chamber 32 is adhesively connected with the specimen holder 39. Further, the retaining wall 392 secures the chamber 32 in position to prevent the chamber 32 from disengagement.

In the fourth embodiment, two inclined spacers (not shown) can be mounted respectively in the upper and lower buffer rooms 38 and 38' in the manner shown in FIG. 6, to increase the number of the buffer rooms within the housing 31 without increasing the height of the housing 31. Each of the inclined spacers partitions the upper (lower) buffer room 38 (38') for further creating two auxiliary buffer rooms (not shown). These buffer rooms are pumped differentially to achieve the multilayered depressurization and to enlarge the maneuverability of pumping rates thereof for greater pressure buffering, thus further enabling the pressure of the gas infused into the vapor room 36 to reach 760 torrs (one atmospheric pressure). The operation of the multilayered buffer rooms through the differential pumping is identical to that of the third embodiment.

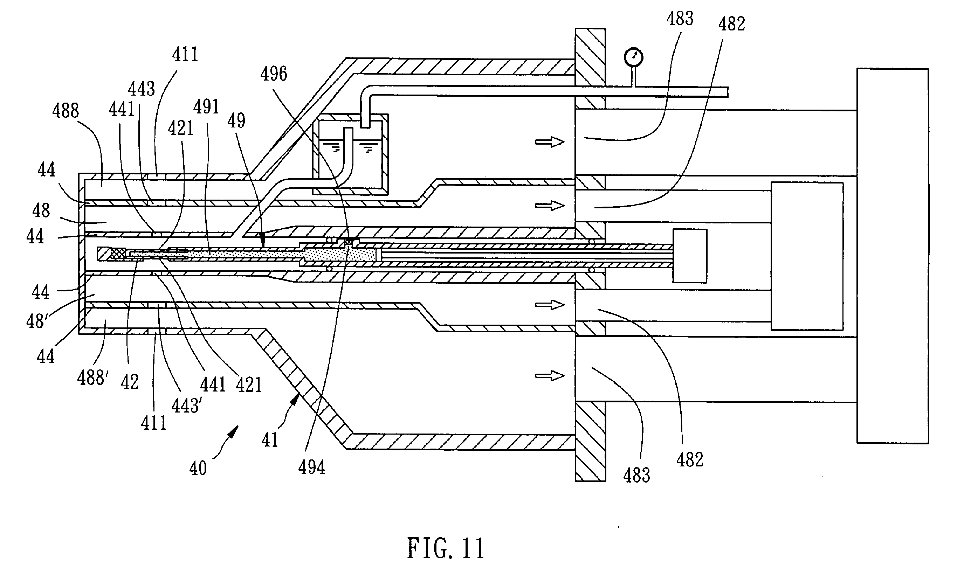

Referring to FIG 11, the device 40 for operating the high-pressure chamber in the vacuum or low-pressure environment and observing the operation in accordance with a fifth preferred embodiment of the present invention is similar to the fourth embodiment, but has the differences described below.

The housing 41 includes a plurality of spacers 44 partitioning the upper buffer room 48 and the lower buffer room 48' into an upper additional buffer room 488 and a lower additional buffer room 488' respectively, which are located above and below the upper buffer room 48 and the lower buffer room 48' respectively. Two buffer apertures 443 and 443' are formed respectively on the spacers 44 located respectively between the upper buffer room 48 and the upper additional buffer room 488, and between the lower buffer room 48' and the lower additional buffer room 488'. The buffer apertures 443 and 443' are coaxially aligned with the inner, outer, and vapor apertures 441 and 411 and 421. The housing 41 includes two pumping ports 482 corresponding respectively to the upper and lower buffer rooms 48 and 48', and another two pumping ports 483 corresponding respectively to the upper and lower additional buffer rooms 488 and 488'. The specimen holder 49 has an inlet 494 formed at its one side for communication with the guiding pipe 491. A seal 496 is mounted to the inlet 494.

The operation of the fifth embodiment is identical to the third embodiment such that no further description is necessary. It is to be noted that the inlet 494 abuts the chamber 42 to shorten the distance between the chamber 42 and where the fluid specimen 100 is infilled, thus facilitating and quickening filling of the fluid specimen 100.

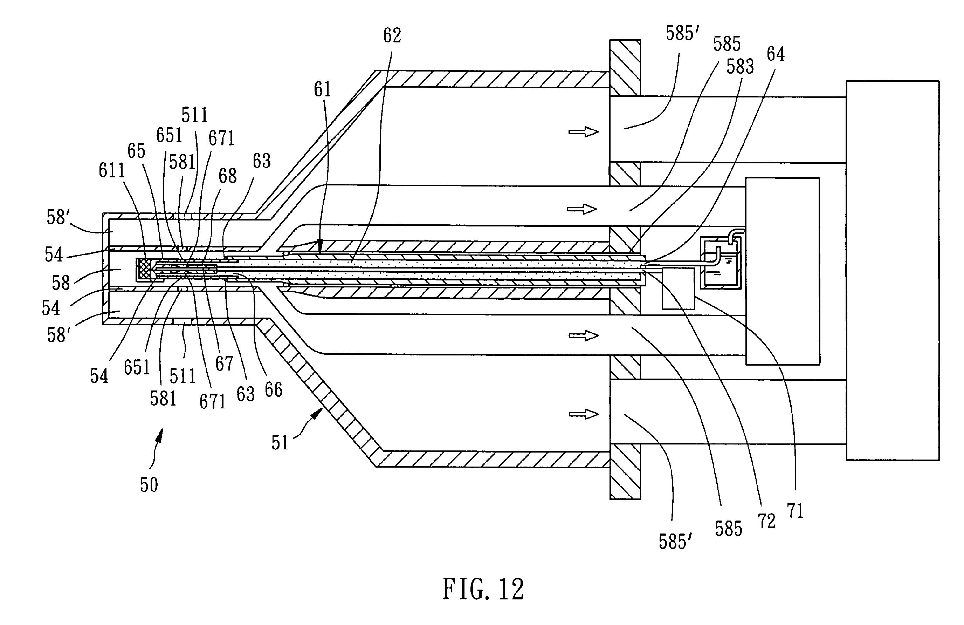

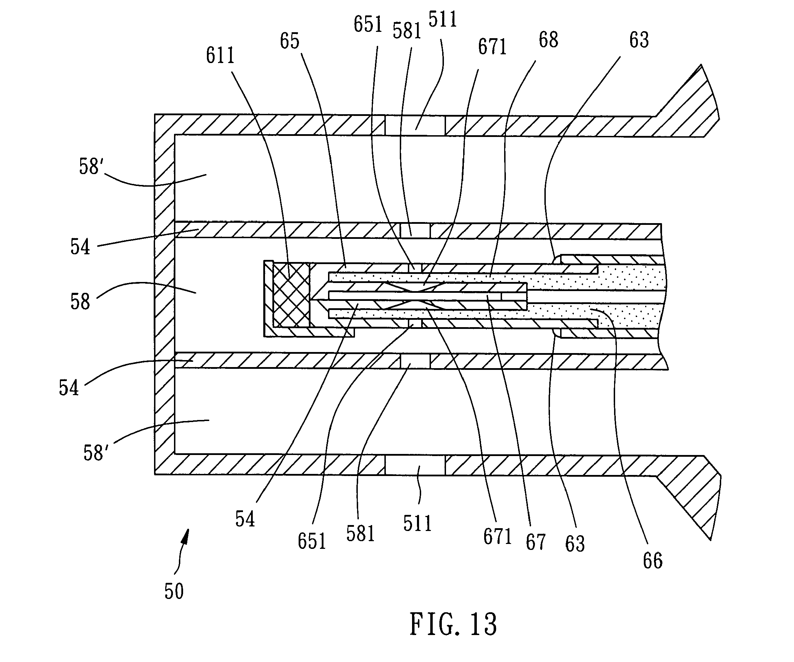

Referring to FIG 12 and 13, the device 50 for operating the high-pressure chamber in the vacuum or low-pressure environment and observing the operation in accordance with a sixth preferred embodiment of the present invention includes a housing 51 and a specimen holder 61.

The housing 51 includes at least one spacer 54 therein for further partitioning its interior space into a buffer room 58 and an additional buffer room 58' formed outside the buffer room 58. The spacer 54 located between the buffer room 58 and the additional buffer room 58' has at least two buffer apertures 581 located on top and bottom sides of the buffer room 58. The housing 51 has two outer apertures 511 formed on its top and bottom sides for communication with the vacuum section, an insertion slot 583 for communication with the buffer room 58, two pumping ports 585 corresponding to the buffer room 58, and another two pumping ports 585' corresponding to the additional buffer room 58'.

The specimen holder 61 is inserted through the insertion slot 583 into the buffer room 58, and has a gas guiding pipe 62 formed therein. A vapor box 65 is adhesively mounted to a front end of the specimen holder 61, having an opening 66 at its one end for communication with the gas guiding pipe 62. The specimen holder 61 has a gas inlet 64 for communication with the gas guiding pipe 62. A retaining wall 611 is formed in the specimen holder 61 for surrounding and positioning the vapor box 65. A chamber 67 is formed in the vapor box 65 by the spacers 54, containing a fluid therein. A pressurizer 71 communicates with the chamber 67 through a guiding pipe 72 for infusing a specimen of gas or liquid or a mixture of the gas and liquid into the chamber 67. A vapor room 68 is formed outside the chamber 67 and located inside the vapor box 65. Two vapor apertures 671 for communication between the chamber 67 and the vapor room 68 are formed respectively on top and bottom sides of the chamber 67. Each of the vapor apertures 671 is taper-shaped, whereby the thickness of each sidewall is the smallest at the center of the sidewall surrounding the vapor aperture 671. Two inner apertures 651 for communication between the vapor room 68 and the buffer room 58 are formed on top and bottom sides of the vapor box 65. The vapor, inner, outer, and buffer apertures 671 and 651 and 511 and 581 are coaxially aligned with one another.

The operation of the sixth embodiment, in which the housing includes multilayered buffer rooms, is identical to that of the third embodiment such that no further description is necessary. The temperature of the sidewall of the gas guiding pipe 62 as well as that of the buffer rooms 58 and 58' is set slightly larger than that of the gas (mixture of the liquid vapor and a specific gas) infused through the gas inlet 64 to prevent the infused vapor from condensation during operation of the sixth embodiment.

In the sixth embodiment, two inclined spacers (not shown) can alternatively be mounted at top and bottom sides of the additional buffer room 58' respectively in the manner shown in FIG 6 without increasing the height of the housing 51, further creating two extra additional buffer rooms (not shown), to enable the housing 51 to have more buffer rooms 58 than the housing of the third embodiment and effect the multilayered depressurization while enabling more flexible control of the pumping rates of the multilayered buffer rooms, resulting in enhanced multilayered pressure buffering (depressurization). The operation of depressurization of the multilayered buffer rooms by differential pumping is referred to that of the third embodiment. The increased number of differentially pumped buffer rooms more than that of the third embodiment enables both the pressure inside the vapor room 68 and the corresponding pressure inside the chamber 67 to reach pressure higher than one atmospheric pressure.

The device 50 of the sixth embodiment with extra additional buffer rooms (not shown) created by mounting the inclined spacers inside the additional buffer room 58' can provide a high-pressure gas chamber of pressure higher than one atmospheric pressure in the vacuum or low-pressure environment by means of which the pressurizer 71 infuses a gas instead of the liquid into the chamber 67 to keep the pressure of the chamber higher than one atmospheric pressure. There is an alternative operation in the sixth embodiment that the user can evacuate the vapor room 68 through the gas inlet 64 to enable the vapor room 68 to become another extra added buffer room. In other words, by means of the multilayered differential pumping, the optimum gas pressure provided by the pressurizer 71 into the chamber 67 can thus be greatly increased.

In conclusion, the present invention includes advantages as follows.
1. The present invention provides a stable fluid environment in the the vacuum or low-pressure environment to keep the fluid specimen in liquid or gas under standard atmospheric pressure or higher within a temperature range between its freezing and boiling points, enabling observation and analysis of the fluid specimen. The outer, inner, vapor, and buffer apertures are coaxially aligned with one another for penetration of the electron beam of the electron microscope or high-coherent beam of other device, such as an ion beam, atomic beam, neutron beam, laser beam, or x ray, for the observation or analysis of the fluid inside the chamber.
2. The present invention can reduce the overall height of the housing or the thinner part down to 1 1cm and smaller to directly put the housing or the thinner part between the two pole pieces of the electron microscope without alteration of the original design of electron microscope to provide the fluid environment whose pressure is equal to or higher than that outside the electron microscope for the observation and analysis.
3. The present invention can allow the fluid specimen to be a live cell or other specimen inside the chamber for observation of the live cell or other specimen under the environmental temperature, such as body temperature and room temperature, and one atmospheric pressure.

It is to be noted that the temperature, liquid/vapor pressure, pumping rate, and the diameters of the vapor, inner, outer, and buffer apertures are intended merely by way of example and not to limit the scope of the present invention, and that variations of the diameter of aforesaid apertures, vapor and gas pressure, or pumping rate are still included within the scope of the present invention.

## Claims

1. A method of operating a high-pressure chamber in a vacuum or low-pressure environment and observing the operation, comprising the steps of:
(a) preparing a housing, wherein said housing has a chamber therein and at least one spacer partitioning its interior space into at least one vapor room formed outside said chamber and at least one buffer room formed outside said vapor room, said chamber contains a fluid specimen, a pressurizer is connected with said chamber for providing said fluid specimen with a predetermined pressure, two vapor apertures are formed on a top side and a bottom side of said chamber for communication with said vapor room, two inner apertures are formed on said at least one spacer between said vapor and said buffer room for communication between said vapor and buffer room, said two inner apertures are located respectively above and below said vapor aperture, two outer apertures are formed on a top side and a bottom side of said housing for communication with the vacuum section outside said housing, said outer, inner, and vapor apertures are coaxially aligned with one another, and said housing has a gas inlet corresponding to said vapor room and a pumping port corresponding to said buffer room;
(b) putting said housing in the vacuum or low-pressure environment and keep a predetermined temperature difference between each two of said chamber, vapor, and buffer rooms;
(c) maintaining said fluid specimen inside said chamber at a predetermined pressure provided by said pressurizer, wherein said predetermined pressure is greater than the ambient pressure outside said housing, infusing a gas into said vapor room, and controlling the pressure difference between said vapor room and said chamber to be lower than a critical pressure that said fluid specimen flows like liquid out of said vapor aperture to prevent said fluid specimen from flowing out of said vapor aperture, wherein said fluid specimen slowly volatilizes through said vapor aperture into said vapor room; meanwhile, the vapor and gas inside said vapor room exhaust through said inner apertures into said buffer room; and
(d) evacuating said buffer room through said pumping port at a predetermined rate to pump out said vapor and gas from said buffer room and to prevent said vapor and gas from leaking through said outer apertures outside said housing;
whereby a high-pressure chamber is provided in the vacuum or low-pressure environment and the observation of said fluid specimen can be done through said outer, inner, and vapor apertures.

2. The method as defined in claim 1, wherein each of said outer apertures is larger in diameter than said inner aperture.

3. The method as defined in claim 1, wherein a temperature of said fluid specimen is equal to a temperature of said chamber; and a temperature of the vapor infused into said vapor room in step (c) is not larger than the temperatures of said vapor room and said chamber.

4. The method as defined in claim 1, wherein said fluid specimen is a liquid specimen; said gas in step (c) is selected from the group consisting of a vapor of the liquid specimen inside said chamber, a specific gas, and a mixture of said vapor and said specific gas.

5. The method as defined in claim 4, wherein a temperature of said specific gas is not smaller than a temperature of said vapor of said liquid specimen.

6. The method as defined in claim 4, wherein said specific gas is a gas selected from the group consisting of nitrogen, oxygen, carbon dioxide, an inert gas, and a mixture of them.

7. The method as defined in claim 1, wherein said predetermined pressure provided by the pressurizer in step (c) for working on said fluid specimen is larger than 50 torrs.

8. The method as defined in claim 1, wherein said pressurizer in step (a) also supplies said chamber with said fluid specimen.

9. The method as defined in claim 1, wherein the predetermined temperature difference indicated in step (b) is defined within 10 degrees Celsius (10°C).

10. The method as defined in claim 1, wherein step (c) further comprises operations of evacuating said vapor room through said gas inlet, keeping a predetermined temperature difference of said vapor room and said chamber, infilling said fluid specimen or other desired material into said chamber by said pressurizer to enable said infilled material to enter said chamber by difference of pressure or concentration between said vapor room and said chamber, infusing the gas into said vapor room and continuing evacuation of said buffer room after said chamber is filled with said fluid specimen, and then infusing the gas into said vapor room through said gas inlet and controlling it to have a predetermined temperature and pressure and prevent said fluid specimen from flowing out of said vapor aperture due to the pressure difference between said chamber and said vapor room, wherein said fluid specimen in liquid volatilizes through said vapor aperture and exhausts into said vapor room, and said pressurizer keeps supplementing said fluid specimen to maintain an amount of said fluid specimen inside said chamber.

11. A device for operating a high-pressure chamber in a vacuum or low-pressure environment and observing the operation, comprising:
a housing having a chamber located therein and at least one spacer partitioning an interior space of said housing into at least one vapor room formed outside said chamber and at least one buffer room formed outside said vapor room, said chamber containing a fluid, a pressurizer being connected with said chamber for providing said fluid with a predetermined pressure, said chamber having two vapor apertures on its top and bottom sides for communication with said vapor room, two inner apertures being formed on said at least one spacer between said vapor room and said buffer room for communication between said vapor and buffer rooms, said two inner apertures being located respectively above and below said vapor aperture, said housing having two outer apertures formed on its top and bottom sides for communication with outside of said housing, said inner, outer, and vapor apertures being coaxially aligned with one another, said housing having at least one gas inlet corresponding to said vapor room and at least one pumping port corresponding to said buffer room.

12. The device as defined in claim 11, wherein each of said vapor apertures has a diameter of 5-100µm; each of said inner apertures has a diameter of 10-200µm; each of said outer apertures has a diameter of 20-800µm, and said inner apertures are smaller in diameter than said outer apertures.

13. The device as defined in claim 11, wherein said fluid specimen in liquid inside said chamber is smaller than 30µm in thickness.

14. The device as defined in claim 11, wherein said housing is not larger than 1cm in overall height.

15. The device as defined in claim 11, wherein said chamber is connected with a guiding pipe at its one side, and said pressurizer is a liquid pressurizer and connected with said guiding pipe.

16. The device as defined in claim 11, wherein said housing comprises two inclined spacers mounted therein and located respectively above and below said two inner apertures for creating two auxiliary buffer rooms inside said buffer room, each of said inclined spacers having a buffer aperture coaxially aligned with said inner and outer apertures, each of said auxiliary buffer rooms corresponding to a pumping port of said housing.

17. The device as defined in claim 16, wherein each of said auxiliary buffer rooms is larger in pumping rate than said buffer room.

18. The device as defined in claim 16, wherein said gas infused into said vapor room keeps the pressure inside said vapor room over 760 torrs; each of said auxiliary buffer rooms has a pumping rate over 160 L/sec; and said buffer room has a pumping rate over 240 L/sec.

19. The device as defined in claim 16, wherein said buffer aperture has a diameter of 10-400µm and is between respective diameters of said inner and outer apertures.

20. The device as defined in claim 11, wherein said housing comprises a thinner part at its one side; and said inner and outer apertures are located on said thinner part.

21. The device as defined in claim 11, wherein said housing comprises a plurality of said spacers further partitioning its interior space into two said buffer rooms, said two buffer rooms being defined as an upper buffer room and a lower buffer room, said upper and lower buffer rooms being located respectively above and below said vapor room.

22. The device as defined in claim 21, wherein said housing further comprises an upper additional buffer room and a lower additional buffer room, said upper and lower additional buffer rooms being located respectively above and below said upper and lower buffer rooms, two buffers apertures being formed respectively on said spacers located respectively between said upper buffer room and said upper additional buffer room and between said lower buffer room and said lower additional buffer room, said two buffer apertures being coaxially aligned with said vapor, inner, and outer apertures.

23. The device as defined in claim 11, wherein each of said vapor apertures is taper-shaped, whereby the thickness of each sidewall is the smallest at the center of the sidewall surrounding said vapor aperture.

24. The device as defined in claim 11 further comprising a hollow specimen holder, wherein said specimen holder has a guiding pipe formed therein; said housing has an insertion slot for communication with said vapor room, said specimen holder being inserted through said insertion slot into said vapor room; said chamber is a box-like member and partially embedded into said specimen holder, said chamber having an opening for communication with said guiding pipe; and said pressurizer is connected with said guiding pipe.

25. The device as defined in claim 24, wherein said chamber is connected with said specimen holder by an adhesive.

26. The device as defined in claim 24, wherein said specimen holder comprises a retaining wall surrounding said chamber.

27. The device as defined in claim 24, wherein said specimen holder comprises an inlet formed at a side thereof for communication with said guiding pipe, a seal being mounted to said inlet.

28. A device for operating a high-pressure chamber in a vacuum or low-pressure environment and observing the operation, comprising:
a housing having at least one spacer partitioning its interior space into a buffer room formed therein and an additional buffer room formed outside said buffer room, said at least one spacer between said buffer room and said additional buffer room having at least two buffer apertures, said at least two buffer apertures being located respectively on a top side and a bottom side of said buffer room, said housing having two outer apertures formed respectively on its top and bottom sides for communication with outside thereof, an insertion slot for communication with said buffer room, and two pumping ports corresponding respectively to said buffer room and said additional buffer room;
a specimen holder having a gas guiding pipe formed therein, a vapor box being partially embedded into a front end of said specimen holder, a chamber being formed inside said vapor box by a plurality of spacers, said specimen holder being inserted through said insertion slot into said buffer room, said vapor box having an opening formed at its one end for communication with said gas guiding pipe, said specimen holder having a gas inlet for communication with said gas guiding pipe, said chamber being infilled with a fluid, a pressurizer being connected with said chamber through a guiding pipe, said vapor box having a vapor room formed outside said chamber, said chamber having two vapor apertures formed respectively on its top and bottom sides for communication with said vapor room, said vapor box having two inner apertures formed on a top side and a bottom side thereof respectively for communication with said buffer room, and said vapor, inner, buffer, and outer apertures being coaxially aligned with one another.

29. The device as defined in claim 28, wherein said vapor box is connected with said specimen holder by an adhesive.

30. The device as defined in claim 28, wherein said specimen holder comprises a retaining wall surrounding said vapor box.

31. The device as defined in claim 28, wherein said pressurizer infuses fluid selected from the group consisting of a gas, a liquid, and a mixture of the gas and the liquid.

32. The device as defined in claim 31, wherein said vapor room inside said vapor box is evacuated through said gas inlet to function like a buffer room inside said vapor box.
